Europäisches Patentamt

European Patent Office

Office européen des brevets

(11) Veröffentlichungsnummer: **0 304 857 B1**

# (12) EUROPÄISCHE PATENTSCHRIFT

(45) Veröffentlichungstag der Patentschrift: **10.03.93**

(21) Anmeldenummer: **88113678.2**

(22) Anmeldetag: **23.08.88**

(51) Int. Cl.5: **H01L 21/306**, **C23F 1/46**, **C23F 1/24**

(54) **Verfahren und Vorrichtung zum Ätzen von Halbleiteroberflächen.**

(30) Priorität: **27.08.87 DE 3728693**

(43) Veröffentlichungstag der Anmeldung:
**01.03.89 Patentblatt 89/09**

(45) Bekanntmachung des Hinweises auf die
Patenterteilung:
**10.03.93 Patentblatt 93/10**

(84) Benannte Vertragsstaaten:
**DE GB IT**

(56) Entgegenhaltungen:
**AT-B- 377 868**
**US-A- 3 964 957**

(73) Patentinhaber: **Wacker-Chemitronic Gesellschaft für Elektronik-Grundstoffe mbH
Johannes-Hess-Strasse 24
W-8263 Burghausen(DE)**

(72) Erfinder: **Schnegg, Anton, Dr. Dipl.-Chem.
Robert-Koch-Strasse 175
W-8263 Burghausen(DE)**
Erfinder: **Prigge, Helene, Dr. Dipl.-Chem.
Münchner Ring 2
W-8044 Unterschleissheim(DE)**
Erfinder: **Brehm, Gerhard, Dr. Dipl.-Ing.
Forststrasse 27
W-8261 Emmerting(DE)**
Erfinder: **Rurländer, Robert
Thalhausen 13
W-8269 Halsbach(DE)**
Erfinder: **Ketterl, Fritz, Dr. Dipl.-Che.
Schnorrstrasse 5
W-8000 München 40(DE)**

**Beschreibung**

Die Erfindung betrifft ein Verfahren zum Ätzen von Halbleiteroberflächen durch Zusammenwirken von das Halbleitermaterial oxidierenden und das Oxidationsprodukt auflösenden Mitteln sowie eine Vorrichtung zur Durchführung des Verfahrens.

Es ist bekannt, Oberflächen von Elementhalbleitern wie z.B. Silicum oder Germanium mit Hilfe von Ätzlösungen zu behandeln, bei welchen jeweils ein oxidierendes Mittel und ein das dabei erzeugte Oxidationsprodukt auflösendes Mittel zusammenwirken. Beispiele für solche Ätzlösungen sind Mischungen mit beispielsweise Salpetersäure, Dichromat oder Permanganat als oxidierendem Mittel und Flußsäure als das Oxidationsprodukt, letztendlich also z.B. Silicium- oder Germaniumdioxid, auflösendem Mittel. Vielfach enthalten diese bekannten Ätzlösungen noch Verdünnungsmittel wie beispielsweise Wasser, Essigsäure, Glycerin, Phosphorsäure oder, gemäß der AT-PS 377 868, Schwefelsäure. In der genannten Druckschrift sind auch zahlreiche weitere gebräuchliche Ätzlösungen diskutiert.

Mit zunehmender Einsatzdauer läßt bei diesen bekannten Ätzmischungen die Wirkung jedoch in immer stärkerem Maße nach, so daß sie häufig erneuert werden müssen, schon um reproduzierbare Ergebnisse des Ätzvorganges zu gewährleisten. Dies hat einerseits einen beträchtlichen Bedarf an unverbrauchten Ausgangsmaterialien zum Ersatz verbrauchter Komponenten zur Folge, während andererseits diese Mengen verbrauchter Ätzmischungen auch entsorgt werden müssen, was häufig mit Umweltbelastungen verbunden ist.

Aufgabe der Erfindung war es daher, ein umweltfreundliches Verfahren anzugeben, welches diese genannten Nachteile vermeidet und es ermöglicht, Silicium- oder Germaniumoberflächen bei geringem Verbrauch an Ätzmischungen zu ätzen.

Gelöst wird die Aufgabe durch ein Verfahren, welches dadurch gekennzeichnet ist, daß die Mittel in schwefel- und/oder phosphorsaurem Trägermedium in einem Kreislauf geführt werden, wobei

a) die bei der Oxidation gebildeten Reduktionsprodukte mit Hilfe von Sauerstoff erneut zu das Halbleitermaterial oxidierenden Mitteln aufoxidiert werden,

b) aus dem bei der Auflösung des Oxidationsproduktes entstehenden Reaktionsprodukt das auflösende Mittel erneut freigesetzt wird, und

c) die Mittel wieder in das Trägermedium überführt und erneut zur Einwirkung auf die Halbleiteroberflächen gebracht werden, während die gebildeten festen Rückstände abgetrennt und aus dem Kreislauf entfernt werden

Als Trägermedium, in dem die beim eigentlichen Ätzvorgang chemisch wirksamen oxidierenden oder auflösenden Mittel vorgelegt werden, wird in der Regel Schwefelsäure eingesetzt. Bewährt hat sich dabei insbesondere konzentrierte, d.h. mindestens 95 gew.-%ige Schwefelsäure, wie sie z.B. im Handel erhältlich ist, obwohl grundsätzlich auch der Einsatz von Säuren mit höherem Wasseranteil nicht ausgeschlossen ist. Oftmals wird der Schwefelsäure ein Anteil von bis zu etwa 90 Gew.-%, vorteilhaft 20 - 80 Gew.-%, bezogen auf die Schwefelsäure, Phosphorsäure beigemischt. Je nach angestrebtem Wassergehalt kann dabei entweder Phosphoroxid (meist $P_4O_{10}$) oder aber Phosphorsäure in die Schwefelsäure eingetragen werden. Erfahrungsgemäß ergeben derartige Mischungen eine besonders glänzende Scheibenoberfläche.Auch der Einsatz von sehr phosphorsäureereichen Trägermedien, bis hin zum vollständigen Ersatz der Schwefelsäure durch Phosphorsäure, ist möglich. Aus Gründen der Vereinfachung soll im folgenden nur von Schwefelsäure als Trägermedium die Rede sein, obwohl sich die genannten Tatsachen sinngemäß auch auf die genannten Schwefelsäure/Phosphorsäuremischungen übertragen lassen.

Als oxidierende Mittel, die das jeweils zu behandelnde Halbleitermaterial anoxidieren und dadurch den abtragenden Angriff der zweiten Ätzmittelkomponente ermöglichen, werden vorteilhaft Mittel auf Basis von Stickstoff-Sauerstoffverbindungen eingesetzt. Eine besonders einfache Möglichkeit bietet die Verwendung von Salpetersäure, welche günstig in konzentrierter Form, d.h. mit einen $HNO_3$-Anteil von mindestens etwa 65 Gew-% eingesetzt wird. Eine andere Variante, welche insbesondere dann zum Einsatz kommt, wenn Ätzmischungen mit geringem Wasseranteil benötigt werden, besteht darin, dem Trägermedium gasförmige Stickoxide oder Salze der Salpeter- oder salpetrigen Säure zuzusetzen, wie beispielsweise Nitrate oder Nitrate des Kaliums oder Natriums. Dabei ist jedoch die Gefahr einer möglichen Kontamination des Halbleitermaterials mit den vorhandenen Kationen zu berücksichtigen. Neben den vor allem wegen der leichten Rückoxidation der beim Ätzvorgang anfallenden Reduktionsprodukte bevorzugten Mitteln auf Stickstoff-Sauerstoffbasis ist auch der Einsatz von anderen Redoxsystemen, beispielsweise auf Chromat- oder Manganat- bzw. Permanganatbasis denkbar, obwohl in diesen Fällen diese Rückoxidation aufwendiger ist.

Als Mittel, das das bei dem oxidierenden Angriff auf der Halbleiteroberfläche entstehende Oxidationsprodukt auflöst und aus dem so erhaltenen Reaktionsprodukt wieder freigesetzt wird, kommt in erster Linie Flußsäure in Frage. Diese wird in den meisten Fällen als wässrige Lösung, günstig in konzentrierter Form, d.h. als mindestens 40 gew.-%ige Lösung, eingesetzt. Wasserarme Ätzmischungen lassen sich herstellen, wenn zu dem schwefelsauren Trägermedium Fluoride wie z.B. Natrium-, Kalium- oder Ammoniumfluorid zugegeben werden, aus denen dann die Flußsäure freigesetzt wird. Andere Möglichkeiten bestehen z. B. im Einblasen von gasförmigen Fluowasserstoff oder in der Zugabe des meist 70 Gew.-%igen, flüssigen ("polymeren") Fluorwasserstoffes.

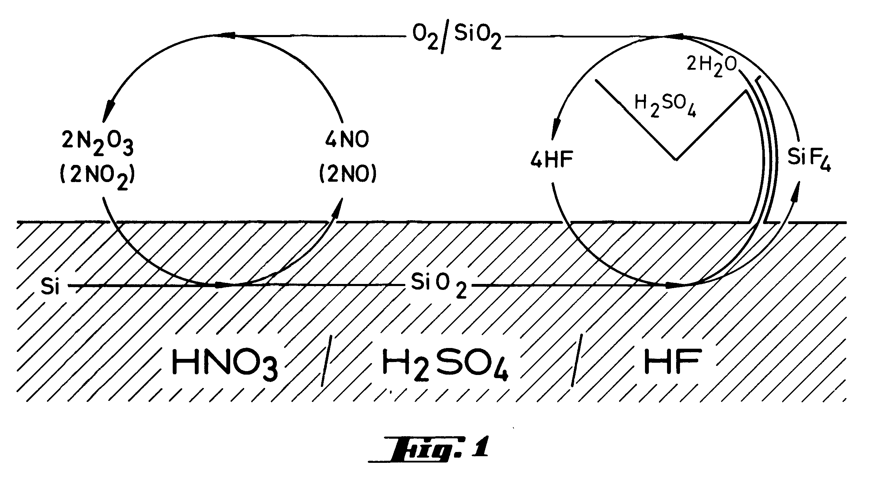

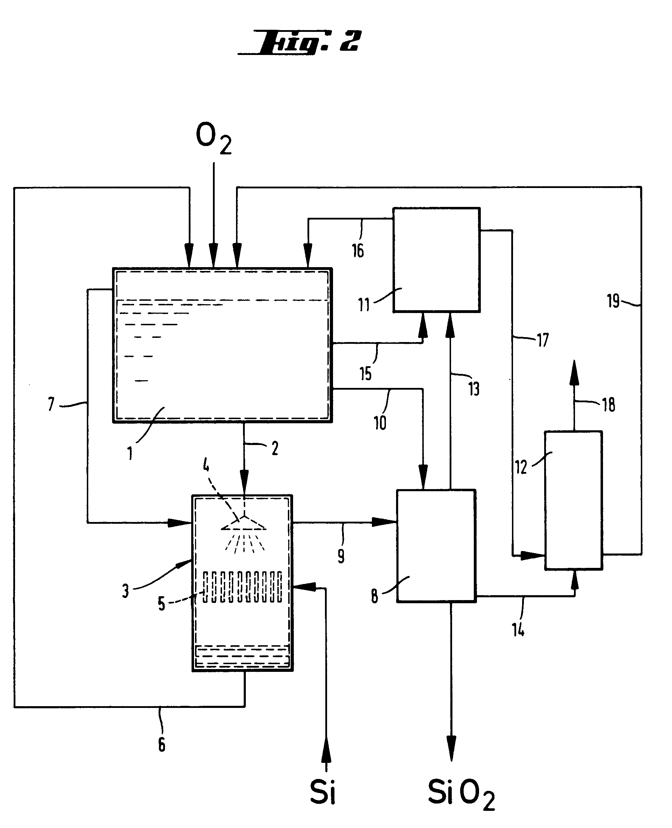

Der Ablauf der Kreisprozesse beim Ätzen von Silicium sowie der Aufbau einer zur Durchführung des Ätzprozesses geeigneten Vorrichtung sind schematisch in den Figuren 1 und 2 dargestellt.

Fig. 1 zeigt beispielhaft das Trägermedium Schwefelsäure, welches zur Ausbildung des ersten Teilkreislaufes Salpetersäure und daneben zur Ausbildung des zweiten Teilkreislaufes Flußsäure gelöst enthält. Wird nun elementares Silicium, beispielsweise in Form von Scheiben, mit dieser flüssigen Phase in Kontakt gebracht, z.B. durch Eintauchen oder Besprühen, so laufen im flüssigen System formal im wesentlichen die nachstehenden Redoxvorgänge ab:

$$\text{I} \quad 4HNO_3 + Si \text{ --------> } 4NO_2 + 2H_2O + SiO_2$$

$$\text{II} \quad 2NO_2 + 2H_2SO_4 \text{ ------> } NO^+HSO_4^- + NO_2^+HSO_4^- + H_2O$$

$$\text{III} \quad 4NO^+HSO_4^- + Si + 2H_2O \text{ ----> } SiO_2 + 4NO + 4H_2SO_4$$

$$\text{IV} \quad 4NO_2^+HSO_4^- + 3Si + 2H_2O \text{ ---> } 3SiO_2 + 4NO + 4H_2SO_4$$

Das entstandene Reduktionsprodukt NO entweicht aus der flüssigen Phase und kann von dem in der Gasphase enthaltenen Sauerstoff nach

$$\text{V} \quad 2NO + O_2 \text{ -----> } 2NO_2 \; (+ \; 2H_2SO_4 \text{ ---> siehe Reaktion II)}$$

oder

$$\text{VI} \quad 2NO + 1/2\,O_2 \text{ -->} N_2O_3 \; (+ \; 2H_2SO_4 \text{ ---> } 2NO^+HSO_4^- + H_2O)$$

zu Verbindungen aufoxidiert werden, welche von der schwefelsauren Phase aufgenommen werden und dort z.B. gemäß Reaktion III oder IV unter eigener Reduktion erneut elementares Silicium zu Siliciumdioxid aufoxidieren können. Somit wird in diesem Teilkreislauf letztendlich elementares Silicium mit Hilfe von Luftsauerstoff in sein Oxid übergeführt.

Im zweiten Teilkreislauf wird das gebildete Siliciumdioxid der Einwirkung der in der Schwefelsäure gelösten Flußsäure unterworfen, was nach

$$\text{VII} \quad SiO_2 + 4HF \text{ ----> } SiF_4 + 2H_2O$$

oder

$$\textbf{VIII} \quad \textbf{SiO}_2 + \textbf{6HF} \text{ ----> } \textbf{H}_2\textbf{SiF}_6 + \textbf{2H}_2\textbf{O} \; \rightleftharpoons \; \textbf{SiF}_4 + \textbf{2HF} + \textbf{2H}_2\textbf{O}$$

unter der Bildung von flüchtigem Siliciumtetrafluorid vor sich gehen kann. Dieses kann in Gegenwart von Wasser schließlich nach

$$\text{IX} \quad SiF_4 + 2H_2O \text{ -----> } SiO_2 + 4HF$$

hydrolysiert werden, wobei der gebildete Fluorwasserstoff erneut in die Schwefelsäure zurückgeführt wird, um weiteres Siliciumdioxid aus dem Oxidationskreislauf aufzulösen, während das im Hydrolyseschritt anfallende Siliciumdioxid z.B. durch Abfiltrieren abgetrennt und aus dem Kreislauf entfernt wird.

Wenn - was der Regelfall ist - die einzelnen Teilschritte des Kreisprozesses nicht in einem Eintopfverfahren, sondern in verschiedenen Stationen durchgeführt werden, hat sich der Einsatz von verschiedenen Temperaturen bewährt. Bei dem eigentlichen Ätzvorgang, der den Teilreaktionskomplexen I bis IV sowie VII and VIII entspricht und der zweckmäßig in einer eigenen Ätzstation, beispielsweise einem Tauchbad oder einer Sprühätzkammer durchgeführt wird, wird vorteilhaft eine Temperatur von 20 bis 50°C, vorzugsweise 30 bis 45°C eingehalten. Der der Reaktion IX entsprechende Hydrolyseschritt erfordert erfahrungsgemäß demgegenüber höhere Temperaturen; in der Hydrolysestation werden daher zweckmäßig 90 bis 200°C, bevorzugt 120 bis 180°C eingestellt. Beim Einsatz wasserarmer Säuremischungen können auch höhere Temperaturen eingesetzt werden. Im Regenerierbereich, in dem die Rückoxidation der beim Ätzvorgang verbrauchten Oxidationsmittel gemäß den Reaktionen V und VI erfolgt, wobei zusätzlich auch gasförmiges HF aus der Reaktion IX in das Trägermedium zurückgeführt werden kann, wird günstig eine Temperatur von 5 bis 50°C, insbesondere 10 bis 30°C eingehalten.

Der schematische Aufbau einer möglichen, zur Durchführung des Verfahrens geeigneten Vorrichtung ist in Fig. 2 dargestellt. Anhand dieser Darstellung wird auch das Verfahren als solches beispielhaft näher erläutert.

In einem Ätzmittelreservoir 1 wird das jeweils gewählte Ätzmittel, beispielsweise ein im Mol-Verhältnis von etwa 1 : 1.5 : 3 : 8 Flußsäure, Salpetersäure, Schwefelsäure und Wasser enthaltendes Gemisch, vorgelegt. Das jeweils eingestellte Mischungsverhältnis kann innerhalb weiter Grenzen variiert werden; so werden sowohl bei Mischungen mit niedrigem Wassergehalt (Mischungsverhältnis z.B. ca. 1 : 1.6 : 6.2 : 6.1) als auch mit hohem Wassergehalt (Mischungsverhältnis z.B. ca. 1 : 1.6 : 6.3 : 11.8) gute Ätzergebnisse erzielt. Zweckmäßig wird das Ätzmittelreservoir 1 auf einer Temperatur von 30 bis 40°C gehalten, beispielsweise durch Thermostatisierung.

Über eine Ätzmittelzuleitung 2 gelangt das Gemisch in die Ätzstation 3, beispielsweise in eine Sprühätzkammer, in der es z.B. mittels Sprühdüsen 4 zur Einwirkung auf die vorgesehenen Substrate, beispielsweise Halbleiterscheiben 5 aus Silicium oder Germanium, gebracht wird. Diese können über eine hier nicht dargestellte Belade- und Entnahmeeinrichtung, beispielsweise in Form einer Ein- und Ausschleuskammer, der Ätzstation zugeführt bzw. entnommen werden. Bewährt hat es sich auch, an der Ätzstation Möglichkeiten zur Gaszufuhr vorzusehen, beispielsweise um durch Zuleitung von Sauerstoff oder sauerstoffhaltigen Gasgemischen wie z.B. Luft bereits dort einen Teil der verbrauchten Oxidationsmittel wieder aufzuoxidieren oder z.B. zum Abschluß des Ätzvorganges mit Hilfe von Inertgasen eine inerte Atmosphäre einzustellen. Die sich nach der Einwirkung auf die Scheiben in der Ätzstation 3 sammelnde Ätzmischung wird über die Ätzmittelrückleitung 6 beispielsweise durch Pumpen wieder in das Ätzmittelreservoir 1 zurückgefördert.

Das rückgeführte Ätzmittel enthält neben den nicht verbrauchten Komponenten auch die beim Ätzvorgang in Lösung überführten Reaktionsprodukte. Zweckmäßig wird auch im Ätzmittelreservoir 1 über eine Gaszufuhr eine sauerstoffhaltige Atmosphäre, z.B. Luft, vorgelegt, um bereits hier eine teilweise Rückoxidation der durch den Ätzvorgang reduzierten Stickstoff-Sauerstoffverbindungen zu ermöglichen. Das hierbei entstehende Gasgemisch kann z. B. als Trägergas über Zuleitung 7 in die Ätzstation eingeleitet werden.

Die Aufbereitung des verbrauchten Ätzmittelgemisches erfolgt günstig in zwei Teilabschnitten, dem Hydrolyseschritt und dem Regenerierschritt.

Die Hydrolysestation 8 besitzt zweckmäßig zwei Zuleitungsmöglichkeiten 9 und 10, welche die Zuführung der sich in der Ätzstation 3 ansammelnden Gase, bzw. von Ätzmittel aus dem Ätzmittelreservoir 1 gestatten, wobei in diese Zuleitungen ggf. auch Vorwärmvorrichtungen für das Gas und insbesondere die Flüssigkeit geschaltet sein können. In der Hydrolysestation selbst wird, beispielsweise mit Hilfe von dampfdurchströmten Wärmetauschern oder elektrischen Heizelementen, die jeweils vorliegende, meist wasserreiche Säuremischung auf eine Temperatur von vorzugsweise 120 bis 180°C eingestellt. Bei diesen Bedingungen reagiert das beim Ätzvorgang gebildete $SiF_4$ mit dem vorhandenen Wasser nach Gleichung IX unter Rückumwandlung in Fluorwasserstoff und $SiO_2$. Dieses anfallende $SiO_2$ kann beispielsweise durch Filtrieren oder Zentrifugieren aus der flüssigen Phase abgetrennt und entfernt werden; es läßt sich z.B. zur Kontrolle der Abtragsraten verwenden, da der darin enthaltene Siliciumanteil im wesentlichen der beim Ätzvorgang abgetragenen Menge von elementarem Silicium entspricht.

Der bei der Hydrolysereaktion entstehende Fluorwasserstoff fällt wegen seiner geringen Löslichkeit in heißen schwefelsauren Medien hauptsächlich in der Gasphase an, die daneben noch Stickoxide und Sauerstoff bzw. Luft enthält. Im Regenerierbereich werden die in der Gasphase vorliegenden, für den Ätzvorgang benötigten Gase ggf. noch oxidiert und in den gelösten Zustand rücküberführt, um die Lösung anschließend zum erneuten Einsatz im Kreislauf wieder in das Ätzmittelreservoir einspeisen zu können.

Zweckmäßig wird der Regenerierbereich in mehrere, in der Regel zwei Regenerierstationen 11 and 12 unterteilt, die jeweils über Zuleitungen 13 und 14 an die Hydrolysestation angeschlossen sind. Eine solche Unterteilung ist zwar nicht zwingend vorgeschrieben, ist aber im allgemeinen wirkungsvoller als Anordnungen mit einer einzigen Regenerierstation.

Die Regenerierstation 11, die z.B. in Form einer Absorbersäule gestaltet sein kann, wird dabei über eine Zuführung 15 mit Ätzmischung aus dem Ätzmittelreservoir 1 versorgt. Diese wird dort von den über die Zuleitung 13, in die ggf. ein Filter eingeschaltet sein kann, aus der Hydrolysestation 8 abgeleiteten Gasen durchströmt, welche im wesentlichen Fluorwasserstoff, Stickoxide und geringe Anteile Luft bzw. Sauerstoff enthalten. Zweckmäßig wird die vorhandene flüssige Phase auf einer Temperatur unterhalb 50°C gehalten, um eine ausreichende Aufnahme der Gase, insbesondere des Fluorwasserstoffes zu gewährleisten. Kontinuierlich oder chargenweise kann die solchermaßen angereicherte Ätzlösung über die Rückführung 16 wieder dem im Ätzmittelreservoir 1 vorhandenen Ätzmittelvorrat zugefügt werden.

Über die Ableitung 17, in welche ggf. eine hier nicht dargestellte Abgasleitung aus dem Ätzmittelreservoir 1 einmünden kann, wird die verbliebene Gasphase in die zweite Regenerierstation 12 überführt, welche zugleich über die Zuleitung 14 mit aus der Hydrolysestation 8 stammender, von $SiO_2$ befreiter Ätzmischung beschickt wird. Von dieser werden die noch gasförmig verbliebenen Restanteile des Fluorwasserstoffes und der Stickoxide absorbiert, so daß in der Gasphase schließlich im wesentlichen nur der nicht verbrauchte Sauerstoff bzw. die sauerstoffhaltige Gasmischung, insbesondere Luft, verbleibt. Diese kann, meist nach Durchgang durch einen ggf. noch vorhandene störende Rückstände zurückhaltenden Filter, über den Auslaß 18 aus dem System abgeleitet werden. Das verbleibende angereicherte Ätzmittel wird schließlich über die Rückleitung 19 wieder in das Ätzmittelreservoir 1 eingebracht. Zweckmäßig wird auch die Regenerierstation 12 als Absorbersäule ausgelegt, in der beispielsweise durch Gegenstrom für einen engen Kontakt zwischen der flüssigen und der Gasphase gesorgt wird.

In vielen Fällen hat es sich bewährt, den Ätzkreislauf (über die Leitungen 2 und 6) und den Aufbereitungskreislauf nicht parallel laufen zu lassen, sondern mit der Ätzmischung abwechselnd zu ätzen, nach Absinken der Abtragsrate unter einen bestimmten, im allgemeinen in Vorversuchen ermittelten Grenzwert den Ätzvorgang zu unterbrechen und danach die Aufbereitung des Ätzmittels in Hydrolyse- und Regenerierstation einzuleiten. Anschließend kann dann der Ätzvorgang fortgesetzt werden. Eine vorteilhafte Ausgestaltung des Erfindungsgedankens besteht auch darin, parallel in das System zwei oder mehrere Ätzstationen einzuschalten, die sich dann beispielsweise alternierend beschicken bzw. entladen lassen, während parallel dazu der Ätzvorgang abläuft.

Um ein Entweichen der während des Prozesses anfallenden Gase zu verhindern, hat es sich bewährt, die Ätzanlagen bei gegenüber dem Atmosphärendruck geringfügig vermindertem Druck zu betreiben. Ein solches Vorgehen ist jedoch nicht zwingend vorgeschrieben.

Das erfindungsgemäße Verfahren eignet sich vor allem zum Einsatz bei Elementhalbleitern wie insbesondere Silicium oder Germanium. Es zeichnet sich durch äußerst geringen Chemikalienbedarf und -verbrauch aus, da letztlich nur die jeweils beim Chargenwechsel ausgetragenen Mengen an flüssigen und gasförmigen Komponenten ersetzt werden müssen. Zweckmäßig wird daher die Zusammensetzung des Ätzmittels ständig oder periodisch analytisch überwacht, so daß ggf. durch Nachchargieren von Komponenten, einzeln oder im Gemisch, diese Zusammensetzung innerhalb der gewünschten Grenzen eingehalten oder wiederhergestellt werden kann. Wegen des niedrigen Chemikalienbedarfes und -verbrauchs ist die von dem erfindungsgemäßen Ätzverfahren verursachte Umweltbelastung äußerst gering.

Nachstehend wird das Verfahren anhand der Ausführungsbeispiele näher erläutert:

Beispiel 1:

Das Verfahren wurde in einer analog der Fig. 2 gestalteten Anordnung durchgeführt. Im Ätzmittelreservoir, einem zylinderförmigen Behältnis aus Polytetrafluorethylen, wurden ca. 10 l Ätzmittel (Zusammensetzung ca. 3 mol/l HF, ca. 3,3 mol/l $HNO_3$, ca. 11,5 mol/l $H_2SO_4$, ca. 15 mol/l $H_2O$) vorgelegt und auf einer Temperatur von ca. 40°C gehalten.

In der als Sprühätzkammer gestalteten Ätzstation aus Polytetrafluorethylen konnten in einer aus demselben Material gefertigten Prozeßhorde jeweils 20 Siliciumscheiben (Durchmesser ca. 7,5 cm, Scheibendicke ca. 500 μm) der Wirkung des Ätzmittels ausgesetzt werden.

Die ebenfalls aus Polytetrafluorethylen gefertigte Hydrolysestation bestand aus einem mit einem Kondensationsaufsatz versehenen Rieselwäscher, in welchem eine relativ wasserreiche Schwefelsäure (ca. 30 mol/l $H_2O$, ca. 8,9 mol/l $H_2SO_4$) umgepumpt und dabei auf ca. 140°C gehalten wurde. In den Kreislauf eingeschaltet war zur Abtrennung des anfallenden festen Hydrolyseproduktes $SiO_2$ ein Membranfilter aus Polytetrafluorethylen.

Beide Regenerierstationen des Regenerierbereiches waren ebenfalls als Rieselwäscher gestaltet, in denen die anfallenden Gasgemische zur Absorption im Gegenstrom mit der Ätzmischung geführt werden konnten. Die Temperatur in diesem ebenfalls aus Polytetrafluorethylen gefertigten Anlagenteil war auf ca. 15°C eingestellt.

Während des eigentlichen Ätzvorganges wurde die Ätzstation jeweils mit 20 in einer Prozeßhorde angeordneten Siliciumscheiben der genannten Spezifikation beschickt, welche während ca. 4 Minuten über die Sprühdüsen mit der umgepumpten Ätzmischung aus dem Ätzmittelreservoir besprüht wurden. Bei diesem Vorgang wurden in Mittel von den Scheiben ca. 42 $\mu$m (entsprechend der Auflösung von insgesamt ca. 8,4 g Silicium) abgetragen; die erhaltenen Scheibenoberflächen waren glänzend. Die Abtragsrate wurde stichprobenartig jeweils durch Rückwägung der geätzten Scheiben überwacht.

Die beim Ätzvorgang entstehenden Gase, im wesentlichen also Siliciumtetrafluorid und nitrose Gase, wurden mit Hilfe eines Luftstroms nach dessen Durchgang durch das Ätzmittelreservoir kontinuierlich aus der Ätzstation in die Hydrolysestation übergeführt. Dort wurde im Gegenstrom das Siliciumtetrafluorid hydrolysiert, wobei das gebildete $SiO_2$ in der flüssigen Phase verblieb und im Filter zurückgehalten wurde, während der gebildete Fluorwasserstoff zusammen mit den bereits teilweise mit Hilfe des Luftsauerstoffes wieder aufoxidierten nitrosen Gasen mit dem Luftstrom aus der Hydrolysestation ausgetragen wurde.

Beim Durchgang durch die beiden Regenerierstationen wurden die nitrosen Gase rückoxidiert und, wie auch der Fluorwasserstoff, absorbiert. Zwischen der ersten Regenerierstation und dem Ätzmittelreservoir wurde dabei ein Teil des Ätzmittels kontinuierlich im Kreislauf geführt und somit für eine ständige Rückführung der absorbierten Reaktanten in den Ätzkreislauf gesorgt.

Jeweils nach etwa 5000 geätzten Scheiben wurden die in den verschiedenen Stationen dann vorhandenen Säuremischungen zyklisch ersetzt; und zwar wurde die Säure aus der zweiten Regenerierabteilung dem Ätzmittel im Ätzmittelreservoir zugeschlagen und durch die Säure aus der Hydrolysestation ersetzt. Diese wiederum wurde mit benutzter Ätzmittelmischung beschickt.

Bei dieser Verfahrensweise konnten ca. 6100 Scheiben geätzt werden, bis die Abtragsrate unter den als noch tolerierbar angesehenen Grenzwert von 5 $\mu$m/min abgesunken war.

Durch Nachdosieren von ca. 13,2 Mol Fluorwasserstoff und ca. 1,2 Mol Salpetersäure konnte die Abtragsrate wieder auf den ursprünglichen Wert von ca. 10 $\mu$m/min. gesteigert werden.

Dies entspricht einer Regenerierung von ca. 96,4 % des Fluorwasserstoffes und ca. 99 % der Salpetersäure, jeweils bezogen auf die Ausgangsmengen, durch den Kreisprozeß.

In einem Vergleichsversuch wurden unter ansonsten gleichen Bedingungen Siliciumscheiben geätzt, ohne daß jedoch das Ätzmittel regeneriert wurde. In diesem Fall war bereits nach 220 geätzten Scheiben die Abtragsrate auf 5 $\mu$m/min. abgesunken, so daß ca. 13,2 mol Fluorwasserstoff und ca. 4,4 mol $HNO_3$ nachdosiert werden mußten, um die Abtragsrate wieder auf ca. 10 $\mu$m/min. zu steigern.

Beispiel 2:

In derselben Anlage wurde unter den gleichen Verfahrensbedingungen als Ätzmittel eine Säuremischung der Zusammensetzung

ca. 3 mol/l HF, ca. 3,3 mol/l $HNO_3$, ca. 5,5 mol/l $H_3PO_4$,

ca. 5,8 mol/l $H_2SO_4$, ca. 15,7 mol/l $H_2O$

eingesetzt.

Zu Beginn des Ätzvorganges war in der Hydrolysestation eine Mischung aus ca. 5.5 mol/l $H_3PO_4$, ca. 5,8 mol/l $H_2SO_4$ und ca. 25 mol/l Wasser vorgelegt. Beide Regenerierstationen waren mit Ätzmittel beschickt.

Das Ätzmittel besaß zu Beginn des Ätzvorganges eine Abtragsrate von ca. 10,5 $\mu$m/min; geätzt wurden wieder Siliciumscheiben (Durchmesser ca. 7,5 cm, Dicke ca. 500 $\mu$m).

Bei Durchführung des Verfahrens mit Kreislauf und Aufbereitung in der erfindungsgemäßen Weise konnten ca. 3700 Scheiben geätzt werden, ehe die Abtragsrate auf die als Toleranzgrenze festgelegten 5 $\mu$m/min. abgesunken war.

Ohne Kreislauf und Aufbereitung sank die Abtragsrate des Ätzmittels bereits nach ca. 220 Scheiben auf unter 5 $\mu$m/min.

Beispiel 3:

In der in Beispiel 2 beschriebenen Verfahrensweise wurden Siliciumscheiben mit einem Ätzmittel der Zusammensetzung ca. 3 mol/l HF, ca. 3,3 mol/l $HNO_3$, ca. 2,3 mol/l $H_3PO_4$,

ca. 9,6 mol/l $H_2SO_4$, ca. 13,7 mol/l $H_2O$

geätzt. Die anfängliche Abtragsrate betrug ca. 6 $\mu$m/min., die Ätzdauer ca. 7 min.

Während die Regenerierstationen zu Beginn mit dem Ätzmittel beschickt waren, wurde in der Hydrolysestation eine Säuremischung der Zusammensetzung ca. 2,3 mol/l $H_3PO_4$, ca. 9,6 mol/l $H_2SO_4$, ca. 25 mol/l $H_2O$ vorgelegt.

Wurde das Ätzmittel im Kreislauf geführt und einer Regenerierung unterworfen, war nach ca. 4400 geätzten Scheiben die Abtragsrate auf unter 4 $\mu$m/min. abgesunken.

Ohne Kreislauf und Regenerierung wurde dieser Wert bereits nach ca. 200 geätzten Scheiben unterschritten.

**Patentansprüche**

1. Verfahren zum Ätzen von Halbleiteroberflächen durch Zusammenwirken von das Halbleitermaterial oxidierenden und das Oxidationsprodukt auflösenden Mitteln, dadurch gekennzeichnet, daß die Mittel in schwefel- und/oder phosphorsaurem Trägermedium in einem Kreislauf geführt werden, wobei
   a) die bei der Oxidation gebildeten Reduktionsprodukte mit Hilfe von dem System zugeführtem Sauerstoff erneut zu das Halbleitermaterial oxidierenden Mitteln aufoxidiert werden,
   b) aus dem bei der Auflösung des Oxidationsproduktes entstehenden Reaktionsprodukt das auflösende Mittel erneut freigesetzt wird, und
   c) diese Mittel wieder in das Trägermedium überführt und erneut zur Einwirkung auf die Halbleiteroberflächen gebracht werden, während die gebildeten festen Reaktionsprodukte abgetrennt und aus dem Kreislauf entfernt werden.

2. Verfahren nach Anspruch 1, dadurch gekennzeichnet, daß oxidierende Mittel auf Basis von Stickstoff-/Sauerstoffverbindungen eingesetzt werden.

3. Verfahren nach den Ansprüchen 1 oder 2, dadurch gekennzeichnet, daß als auflösendes Mittel Flußsäure eingesetzt wird.

4. Verfahren nach einem oder mehreren der Ansprüche 1 bis 3, dadurch gekennzeichnet, daß dem schwefelsauren Trägermedium bis zu 90 Gew.-% Phosphorsäure, bezogen auf die Schwefelsäure, zugesetzt werden.

5. Verfahren nach einem oder mehreren der Ansprüche 1 bis 4, dadurch gekennzeichnet, daß die Mittel durch Sprühen auf die Halbleiteroberflächen aufgebracht werden.

6. Verfahren nach einem oder mehreren der Ansprüche 1 bis 5, dadurch gekennzeichnet, daß im Ätzsystem ein unterhalb des Atmosphärendrucks liegender Druck eingestellt wird.

7. Verfahren nach einem oder mehreren der Ansprüche 1 bis 6, dadurch gekennzeichnet, daß die schwefel- und/oder phosphorsaure Lösung bei der Einwirkung auf die Halbleiteroberflächen auf einer Temperatur von 20 bis 50°C gehalten wird.

8. Vorrichtung zur Durchführung des Verfahrens nach den Ansprüchen 1 bis 7, gekennzeichnet durch einen Ätzmittelkreislauf, in welchen mindestens eine, die Zufuhr und Entnahme von Halbleiterscheiben gestattende Ätzstation, mindestens eine die Regenerierung der verbrauchten oxidierenden Komponenten des Ätzmittels gestattende Regenerierstation und mindestens eine die erneute Freisetzung von gebundenen, auflösenden Komponenten des Ätzmittels sowie die Entfernung der dabei anfallenden festen Rückstände gestattende Hydrolysestation eingeschaltet sind.

9. Vorrichtung nach Anspruch 8, gekennzeichnet durch zwei oder mehrere alternierend beschickbare Ätzstationen.

10. Vorrichtung nach den Ansprüchen 8 oder 9, dadurch gekennzeichnet, daß die Ätzstationen als Sprühätzstationen gestaltet sind.

**Claims**

1. Process for etching semiconductor surfaces by the combined action of agents which oxidise the semiconductor material and which dissolve the oxidation product, characterised in that the agents are circulated in sulphuric acid and/or phosphoric acid carrier medium, in which process
   a) the reduction products formed in the oxidation are reoxidised by means of oxygen supplied by the system to form agents which oxidise the semiconductor material,
   b) the dissolving agent is liberated again from the reaction product produced in the dissolution of the oxidation product and
   c) these agents are again transferred to the carrier medium and again caused to act on the semiconductor surfaces, while the solid reaction products formed are separated off and removed from the circuit.

**2.** Process according to Claim 1, characterised in that oxidising agents based on nitrogen/oxygen compounds are used.

**3.** Process according to Claims 1 or 2, characterised in that hydrofluoric acid is used as dissolving agent.

**4.** Process according to one or more of the Claims 1 to 3, characterised in that up to 90% by weight of phosphoric acid, based on the sulphuric acid, are added to the sulphuric acid carrier medium.

**5.** Process according to one or more of the Claims 1 to 4, characterised in that the agents are applied to the semiconductor surfaces by spraying.

**6.** Process according to one or more of the Claims 1 to 5, characterised in that the etching system is adjusted to a pressure lying below the atmospheric pressure.

**7.** Process according to one or more of the Claims 1 to 6, characterised in that the sulphuric and/or phosphoric acid solution is kept at a temperature of 20 to 50°C while acting on the semiconductor surfaces.

**8.** Equipment for carrying out the process according to Claims 1 to 7, characterised by an etchant circuit which incorporates at least one etching station permitting the supply and removal of semiconductor slices, at least one regeneration station permitting the regeneration of the spent oxidising components of the etchant and at least one hydrolysis station permitting the renewed liberation of bound dissolving components of the etchant and also removal of the solid residues produced in the process.

**9.** Equipment according to Claim 8, characterised by two or more etching stations which are loaded alternately.

**10.** Equipment according to Claims 8 or 9, characterised in that the etching stations are designed as spray etching stations.

**Revendications**

**1.** Procédé d'attaque de surfaces de semi-conducteurs par l'action conjointe de produits qui oxydent le matériau dont est fait le semi-conducteur et qui dissolvent la matière oxydée, procédé caractérisé en ce que ces produits sont recyclés dans un milieu véhicule d'acide sulfurique et/ou phosphorique dans les conditions suivantes

a) les produits de réduction formés à l'oxydation sont réoxydés par l'oxygène apporté en produits oxydant le matériau du semi-conducteur,

b) le produit dissolvant est relibéré du produit de réaction formé à la dissolution de la matière oxydée, et

c) ces produits retournent au milieu véhicule pour poursuivre leur action sur la surface du semi-conducteur, les produits de réaction solides formés étant séparés et éliminés du circuit.

**2.** Procédé selon la revendication 1, caractérisé en ce que les produits oxydants sont à base de composés azotés/oxygénés.

**3.** Procédé selon la revendication 1 ou 2, caractérisé en ce que le produit dissolvant est de l'acide fluorhydrique.

**4.** Procédé selon une ou plusieurs des revendications 1 à 3, caractérisé en ce que l'on ajoute au milieu véhicule sulfurique jusqu'à 90% en poids d'acide phosphorique par rapport à l'acide sulfurique.

**5.** Procédé selon une ou plusieurs des revendications 1 à 4, caractérisé en ce que l'on applique les produits en les projetant ou en les pulvérisant sur la surface du semi-conducteur.

**6.** Procédé selon une ou plusieurs des revendications 1 à 5, caractérisé en ce que l'on établit dans le système d'attaque une pression inférieure à la pression atmosphérique.

**7.** Procédé selon une ou plusieurs des revendications 1 à 6, caractérisé en ce que l'on maintient la solution sulfurique et/ou phosphorique à une température de 20 à 50°C au cours de son action sur les des surfaces des semi-conducteurs.

**8.** Dispositif pour exécuter le procédé défini aux revendications 1 à 7 précédentes, dispositif caractérisé par un circuit fermé des produits d'attaque dans lequel sont mis en circuit un ou plusieurs postes d'attaque permettant l'arrivée et la reprise de plaquettes du semi-conducteur, un ou plusieurs postes de régénération pour régénérer les composants oxydants consommés du produit d'attaque, et un ou plusieurs postes d'hydrolyse pour remettre en liberté les composants dissolvants liés et pour éliminer les résidus solides formés.

**9.** Dispositif selon la revendication 8, caractérisé par deux postes d'attaque ou plus pouvant être alimentés en alternance.

**10.** Dispositif selon la revendication 8 ou 9, caractérisé en ce que les postes d'attaque sont des postes par pulvérisation ou projection.

## Fig. 1

EP 0 304 857 B1

# Fig. 2